# EUROPÄISCHE PATENTANMELDUNG

(11) **EP 1 065 503 A2**
(43) Veröffentlichungstag der Anmeldung: **03.01.2001**
(21) Anmeldenummer: 00112096.3
(22) Anmeldetag: 05.06.2000
(51) Int. Cl.: G01N 29/10

(54) **Verfahren und Vorrichtung zur logarithmischen Umwandlung eines Ultraschallmesssignals**

(30) Priorität: 11.06.1999 DE 19926684
(71) Anmelder: SIEMENS AKTIENGESELLSCHAFT, 80333 München (DE)
(72) Erfinder: Quittkat, Jörg, Dipl.-Ing., 63543 Neuberg (DE); Bender, Rudolf, Dipl.-Ing., 35423 Lich (DE); Thiel, Gerhard, 63579 Freigericht (DE)

(57) **Zusammenfassung**

Bei einem Verfahren zur bipolaren logarithmischen Umwandlung eines Ultraschallmesssignals (IN) in ein Ausgangssignal (OUT) wird aus dem Ultraschallmesssignal (IN) ein Polaritätssignal (P) erzeugt, das eine Information über die momentane Polarität des Ultraschallmesssignals (IN) enthält. Das Ultraschallmesssignal (IN) wird einem insbesondere nach dem Prinzip der "successive detection" arbeitenden logarithmischen Verstärker (3) zugeführt. Aus einem Verstärkerausgangssignal (V) wird ein invertiertes Signal und ein nicht-invertiertes Signal erzeugt, aus denen anschließend in zeitlicher Reihenfolge abwechselnd das Ausgangssignal (OUT) in Abhängigkeit vom Polaritätssignal (P) gebildet wird. Bei einem anderen Verfahren wird das Verstärkerausgangssignal (V) einem Analog-Digital-Wandler (41) zugeführt, der ausgangsseitig einen Digitalwert (D) ermittelt. Dem Digitalwert (D) wird ein aus dem Polaritätssignal (P) erzeugtes Vorzeichenbit (VZ) zur Bildung des Ausgangssignals (OUT) in digitaler Form hinzugefügt.

## Beschreibung

Die Erfindung liegt auf dem Gebiet der elektronischen Signalverarbeitung.

Die Erfindung bezieht sich auf ein Verfahren zur Umwandlung eines analogen Ultraschallmesssignals in ein Ausgangssignal, dessen Polarität von der Polarität des Ultraschallmesssignals beeinflußbar ist und dessen Betrag logarithmusartig vom Betrag des Ultraschallmesssignals abhängt. Die Erfindung betrifft außerdem Vorrichtungen zur Umwandlung eines analogen Ultraschallmesssignals in ein Ausgangssignal, dessen Polarität von der Polarität des Ultraschallmesssignals beeinflußbar ist und dessen Betrag logarithmusartig vom Betrag des Ultraschallmesssignals abhängt.

Aus der JP 800 544 24 A1 ist eine elektronische Schaltungsanordnung bekannt, bei der für negative und positive Signalamplituden jeweils ein gesonderter logarithmischer Verstärker vorgesehen ist. Eine solche Schaltung ist aufwendig.

In der JP 801 524 82 A1 ist beschrieben, zur logarithmischen Verstärkung ein Eingangssignal je nach dessen Vorzeichen auf einen abwechselnd invertierenden und nicht-invertierenden Verstärker umzuschalten. Das Schalten reduziert den Dynamikbereich durch entstehende "Umschalt-Spikes" am Eingang eines nachgeschalteten logarithmischen Verstärkers, die insbesondere bei sehr hohen Frequenzen auch nicht mehr ausgefiltert werden können.

In der EP 0 626 763 A3 ist offenbart, zur Dynamikerweiterung eines A/D-Wandlers einen logarithmischen Verstärker, einen linearen A/D-Wandler und eine Umkodierung des Datenformats nach "Floating-Point-Format" anzuwenden.

Bei zahlreichen Anwendungen in der Ultraschallprüftechnik ist es notwendig, zur visuellen Betrachtung und zur Bewertung des Prüfergebnisses das von einem Ultraschalldetektor im Frequenzbereich von ca. 0,1 MHz bis etwa 20 MHz erzeugte analoge, in seiner Polarität alternierende Ultraschallmess- oder prüfsignal in den Bereichen konstanter Polarität näher zu untersuchen. Dabei kommt es auf die Bestimmung der Maximalamplituden der einzelnen Halbwellen des Prüfsignals und auf deren zeitliche Lage an. Hierzu ist es notwendig, das Ultraschallprüfsignal mit großer Bandbreite und mit großem Dynamikumfang (typisch 60 bis 80 dB) unter logarithmischer Verstärkung in ein Ausgangssignal umzuwandeln. Hierzu ist ein bipolar arbeitender logarithmischer Verstärker erforderlich.

Ein einfacher bipolarer logarithmischer Verstärker ist beispielsweise aus dem Buch von U. Tietze und Ch. Schenk mit dem Titel "Halbleiter-Schaltungstechnik", 7. Auflage, Springer, Berlin, 1985, Seite 317, bekannt. Er besteht aus einem mit einer Diode gegengekoppelten Operationsverstärker. Bei den für die Ultraschallprüftechnik geforderten Verstärkungen von bis zu 80 dB weist ein solcher logarithmischer Verstärker eine zu geringe, nur bis etwa 1 MHz reichende Frequenzbandbreite auf.

Ein anderer bipolarer logarithmischer Verstärker wird von der Firma Plessey Semiconductors unter der Bezeichnung SL 531 C vertrieben und ist im Datenbuch mit dem Titel "Linear Integrated Circuit Handbook", vom September 1985, auf Seite 35ff, beschrieben. Dabei ist die logarithmische Verstärkung durch Hintereinanderschaltung mehrerer Kompressionsstufen realisiert. Nachteilig an diesem logarithmischen Verstärker ist, daß die Linearität seiner logarithmischen Transferfunktion für die Ultraschallprüftechnik unzureichend ist.

Weiterhin ist unter der Bezeichnung TL 441 AM in einem Datenhandbuch mit dem Titel "Linear Circuits Volume 3", 1992, auf den Seiten 4-85ff, ein bipolarer logarithmischer Verstärker beschrieben. Nachteilig an diesem logarithmischen Verstärker ist der hohe technische Aufwand, der erforderlich ist, um einen darin vorhandenen Vorverstärker nach Betrag und Phase abzugleichen. Ebenfalls zeitaufwendig ist der erforderliche Linearitätsabgleich. Darüber hinaus hat dieser logarithmische Verstärker den Nachteil einer nur bis zu ca. 6 bis 8 MHz reichenden Frequenzbandbreite, die für die Ultraschallprüftechnik häufig zu gering ist.

Außerdem ist aus der deutschen Patentschrift DE 29 39 617 C2 ein bipolarer logarithmischer Verstärker bekannt, bei dem einem linearen Vorverstärker ein logarithmisch arbeitender Analog-Digital-Wandler nachgeschaltet ist, dessen Ausgangssignal anschließend einem Digital-Analog-Umsetzer zugeführt wird. Der als Parallelwandler ausgebildete Analog-Digital-Wandler arbeitet mit logarithmisch abgestuften Komparatoren, was einen sehr hohen technischen Aufwand mit sich bringt. Weiterhin nachteilig an diesem bipolaren logarithmischen Verstärker ist seine nicht ausreichende Eingangsdynamik (Verstärkung).

Es besteht demzufolge ein Bedarf, ein analoges Eingangssignal resultierend aus einem Ultraschallmesssignal, bei vertretbarem Aufwand, hoher Frequenzbandbreite, großer Eingangsdynamik und über die gesamte Aussteuerung der Eingangsdynamik guter Linearität bipolar logarithmisch umzuwandeln. Der Erfindung liegt demzufolge die Aufgabe zugrunde, sowohl ein Verfahren als auch eine Vorrichtung hierzu anzugeben.

Die verfahrensbezogene Aufgabe wird in einer ersten Variante gemäß der Erfindung dadurch gelöst,
a) daß aus dem Ultraschallmesssignal ein Polaritätssignal erzeugt wird, das eine Information über die momentane Polarität des Ultraschallmesssignals enthält,
b) daß das Ultraschallmesssignal einem logarithmischen Verstärker zugeführt wird,
c) daß aus einem Verstärkerausgangssignal ein nicht-invertiertes Signal und ein invertiertes Signal erzeugt wird, das die gleiche bzw. entgegengesetzte Polarität wie das Verstärkerausgangssignal aufweist, und
d) daß das Ausgangssignal in Abhängigkeit vom Polaritätssignal in zeitlicher Reihenfolge abwechselnd entweder aus dem nicht-invertierten Signal oder aus dem invertierten Signal gebildet wird.

Mit dem Verfahren wird der Vorteil erzielt, daß der verwendete logarithmische Verstärker kein bipolarer logarithmischer Verstärker zu sein braucht, und daß trotzdem die Umwandlung des Ultraschallmesssignals in das Ausgangssignal bipolar stattfindet. Da der verwendete logarithmische Verstärker nicht bipolar arbeiten muß, können die anderen aufgabengemäß genannten Erfordernisse, insbesondere hinsichtlich der Bandbreite und der Eingangsdynamik, in einfacher und preiswerter Weise durch einen bekannten unipolaren logarithmischen Verstärker realisiert werden. Mit anderen Worten: Bei dem Verfahren nach der Erfindung ist das Erfordernis der Bipolarität funktionell vom logarithmischen Verstärker getrennt, so daß dieser hinsichtlich der übrigen Erfordernisse optimierbar ist.

Das nicht-invertierte Signal kann insbesondere mit dem Verstärkerausgangssignal identisch sein und durch eine einfache Leitung am Verstärkerausgang abgegriffen sein. Das nicht-invertierte Signal kann aber auch mittels eines nicht-invertierenden Verstärkers aus dem Verstärkerausgangssignal erzeugt werden. In diesem Fall wird das invertierte Signal vorzugsweise mittels eines invertierenden Verstärkers oder Invertierers aus dem Verstärkerausgangssignal erzeugt, wobei der invertierende Verstärker betragsmäßig die gleiche Verstärkung wie der nicht invertierende Verstärker aufweist. Durch die parallele Verwendung eines nicht-invertierenden Verstärkers und eines invertierenden Verstärkers wird in vorteilhafter Weise erreicht, daß sowohl das nicht-invertierte Signal als auch das invertierte Signal bei der nachfolgenden ZusammenSetzung zum Ausgangssignal die gleiche Laufzeit hinter sich haben.

Insbesondere hat das invertierte Signal den gleichen Betrag aber entgegengesetzte Polarität wie das Verstärkerausgangssignal. Das nicht-invertierte Signal hat insbesondere den gleichen Betrag und die gleiche Polarität wie das Verstärkerausgangssignal.

Die verfahrensbezogene Aufgabe wird in einer zweiten Verfahrensvariante gemäß der Erfindung dadurch gelöst,
a) daß aus dem Ultraschallmesssignal ein Polaritätssignal erzeugt wird, das eine Information über die momentane Polarität des Ultraschallmesssignals enthält,
b) daß das Ultraschallmesssignal einem logarithmischen Verstärker zugeführt wird,
c) daß ein Verstärkerausgangssignal einem Analog-Digitalwandler zugeführt wird, der als Ausgangssignal einen Digitalwert ermittelt, und
d) daß dem Digitalwert ein aus dem Polaritätssignal erzeugtes Vorzeichenbit zur Bildung des Ausgangssignals in digitaler Form hinzugefügt wird.

Bezüglich dieser Verfahrensvariante gelten die gleichen Vorteile wie bei der ersten Verfahrensvariante. Das Erfordernis der Bipolarität wird bei der zweiten Verfahrensvariante im wesentlichen mit Hilfe des Analog-Digital-Wandlers erfüllt, mit Hilfe dessen das bipolare Ausgangssignal durch eine digitale Operation unter Verwendung des Polaritätssignals erzeugbar ist.

Falls das Ausgangssignal in analoger Form benötigt wird, wird bei der zweiten Verfahrensvariante vorzugsweise aus dem Digitalwert mittels eines Digital-Analog-Umsetzers unter Berücksichtigung des Vorzeichenbits das Ausgangssignal in analoger Form erzeugt.

Die nachfolgend beschriebenen Ausgestaltungen und Weiterbildungen beziehen sich auf beide Verfahrensvarianten.

In einer bevorzugten Ausgestaltung ist der logarithmische Verstärker ein demodulierender logarithmischer Verstärker.

Vorzugsweise ist der logarithmische Verstärker ein integrierter Schaltkreis, an dem das Polaritätssignal abgreifbar ist.

Nach einer ganz besonders bevorzugten Ausgestaltung ist der logarithmische Verstärker ein nach dem Prinzip der "successive detection" arbeitender mehrstufiger Verstärker.

Das Prinzip der "successive detection" ist beispielsweise in "Technical Note No. 35T001 - specification definitions for logarithmic amplifiers" der Firma MITEQ beschrieben, veröffentlicht am 21.05.1999 unter der Internet-Adresse http://www.miteq.com/micro/ifsignal/tecnotel.htm. Bei diesem Prinzip werden mehrere Kompressionsstufen mit Verstärkung im Hochfrequenzbereich benutzt, um eine exponentielle Transferfunktion zu emulieren. Das Ausgangssignal jeder Stufe wird einem linearen Detektor zugeführt. Die Ausgangssignale aller linearen Detektoren werden dann in einem einzigen Videoverstärker aufsummiert, von dem das Verstärkerausgangssignal erzeugt wird.

Der besondere Vorteil der nach dem Prinzip der "successive detection" arbeitenden logarithmischen Verstärker liegt in der Kombination eines besonders großen Dynamikbereichs (große Verstärkung) mit besonders kurzen Anstiegs- bzw. Abfallzeiten (rise/settling times). Die Letztgenannten resultieren in einer besonders großen Frequenzbandbreite. Da die einzelnen Kompressionsstufen und der Videoverstärker linear arbeiten, weist ein "successive detection logarithmic amplifier (SDLA)" außerdem eine hervorragende Linearität der logarithmischen Transferkurve auf.

Nach dem Prinzip der "successive detection" arbeitende logarithmische Verstärker sind außerdem in einem Datenblatt der Firma Analog Devices, "Design-In Reference Manual", von 1994, für einen käuflich erhältlichen Verstärker AD606 und in einem Datenblatt der Firma Plessey Semiconductors "Linear IC Handbook", September 1988, Seite 82, für einen käuflich erhältlichen logarithmischen Verstärker mit der Typ-Nr. SL2521 beschrieben.

Nach einer bevorzugten Ausgestaltung wird an einem begrenzten Limiterausgang des logarithmischen Verstärkers das Polaritätssignal abgegriffen. Beispielsweise wird bei einem käuflichen, als integrierter Schaltkreis ausgebildetem logarithmischen Verstärker der begrenzte Limiterausgang zum Abgriff des Polaritätssignals verwendet.

Nach einer alternativen vorzugsweisen Weiterbildung wird das Polaritätssignal am Ausgang eines Nulldurchgangskomparators abgegriffen, dem ein vom Eingangssignal oder Ultraschallmesssignal abhängiges Signal zugeführt wird. Insbesondere ist das abhängige Signal mit dem Ultraschallmesssignal identisch oder diesem proportional.

Die vorrichtungsbezogene Aufgabe wird bezogen auf die Vorrichtung der eingangs genannten Art in einer ersten Ausführungsform gemäß der Erfindung gelöst durch
a) eine Polarisationserkennungseinheit zur Ermittlung der momentanen Polarität des Ultraschallmesssignals,
b) einen logarithmischen Verstärker, dem das Ultraschallmesssignal zuführbar ist,
c) einen dem logarithmischen Verstärker nachgeschalteten Invertierer zum Erzeugen eines invertierten Signals aus dem Verstärkerausgangssignal, wobei das invertierte Signal entgegengesetzte Polarität wie das Verstärkerausgangssignal aufweist, und
d) einen mit der Polaritätserkennungseinheit über eine Steuerleitung in Verbindung stehenden Schalter, mit dem in zeitlicher Reihenfolge abwechselnd entweder ein vom Verstärkerausgangssignal abhängiges nicht-invertiertes Signal oder das invertierte Signal als Ausgangssignal einer Ausgangsleitung zuführbar ist.

Bezüglich der Vorteile dieser Vorrichtung gilt das für das Verfahren der ersten Variante Gesagte analog.

Das nicht-invertierte Signal ist insbesondere mit dem Verstärkerausgangssignal identisch oder diesem proportional.

Die vorrichtungsbezogene Aufgabe wird gemäß der Erfindung in einer zweiten Ausführungsform gelöst durch
a) eine Polarisationserkennungseinheit zur Ermittlung der momentanen Polarität des Ultraschallmesssignals,
b) einen logarithmischen Verstärker, dem das Ultraschallmesssignal zuführbar ist,
c) einen dem logarithmischen Verstärker nachgeschalteten Analog-Digital-Wandler, der als Ausgangssignal einen Digitalwert ermittelt, und
d) eine von der Polaritätserkennungseinheit ausgehende SIGN-Leitung, mit der dem Digitalwert zusätzlich ein Vorzeichenbit zur Bildung des Ausgangssignals in digitaler Form zuführbar ist.

Bezüglich der Vorteile der Vorrichtung in der zweiten Ausführungsform gilt das für das Verfahren der zweiten Variante Gesagte analog.

Vorzugsweise umfaßt die letztgenannte Vorrichtung einen dem Analog-Digital-Wandler nachgeschalteten Digital-Analog-Umsetzer, mit dem aus dem Digitalwert unter Berücksichtigung des Vorzeichenbits das Ausgangssignal in analoger Form erzeugbar ist.

Die nachfolgend beschriebenen bevorzugten Ausgestaltungen und Weiterbildungen beziehen sich auf die Vorrichtungen beider Ausgestaltungen.

Der Vorrichtung kann ein Ultraschallempfänger zugeordnet sein, dessen Ausgangssignal das Ultraschallmesssignal bildet.

Vorzugsweise ist der logarithmische Verstärker ein demodulierender logarithmischer Verstärker.

Außerdem bevorzugt sind der logarithmische Verstärker und die Polaritätserkennungseinheit als integrierte Schaltkreise ausgebildet.

Nach einer ganz bevorzugten Ausgestaltung ist der logarithmische Verstärker ein nach dem Prinzip der "successive detection" arbeitender mehrstufiger Verstärker.

Bei einem solchen "successive detection logarithmic amplifier" (SDLA) ist die Polaritätserkennungseinheit vorzugsweise funktionell gebildet durch eine Endstufe des logarithmischen Verstärkers und einem von der Endstufe ausgehenden begrenzten Limiterausgang, wobei der Limiterausgang mit der Steuerleitung bzw. der SIGN-Leitung in Verbindung steht. Bei dieser Ausgestaltung erfüllen also Bestandteile des SDLA sowohl die Funktion einer Signalverstärkung als auch die Funktion einer Polarisationserkennungseinheit.

Nach einer alternativen bevorzugten Weiterbildung ist die Polarisationserkennungseinheit ein Nulldurchgangskomparator, dem ein vom Eingangssignal oder Ultraschallmesssignal abhängiges Signal zuführbar ist und dessen Ausgang mit der Steuerleitung bzw. der SIGN-Leitung in Verbindung steht.

Vier Ausführungsbeispiele einer Vorrichtung nach der Erfindung werden nachfolgend anhand der Figuren 1 bis 7 näher erläutert. Die Figuren dienen auch der Erläuterung des Verfahrens nach der Erfindung. Es zeigen:
- FIG 1: ein erstes Ausführungsbeispiel einer Vorrichtung nach der Erfindung in der ersten Ausführungsform,
- FIG 2: ein zweites Ausführungsbeispiel einer Vorrichtung nach der Erfindung in der ersten Ausführungsform,
- FIG 3: einen typischen zeitlichen Eingangssignalverlauf,
- FIG 4: einen typischen zeitlichen Verlauf eines Verstärkerausgangssignals eines demodulierenden logarithmischen Verstärkers,
- FIG 5: einen typischen zeitlichen Verlauf des Ausgangssignals einer der Vorrichtungen nach der Erfindung,
- FIG 6: ein drittes Ausführungsbeispiel einer Vorrichtung nach der Erfindung in der zweiten Ausführungsform und
- FIG 7: ein viertes Ausführungsbeispiel einer Vorrichtung nach der Erfindung in der zweiten Ausführungsform.

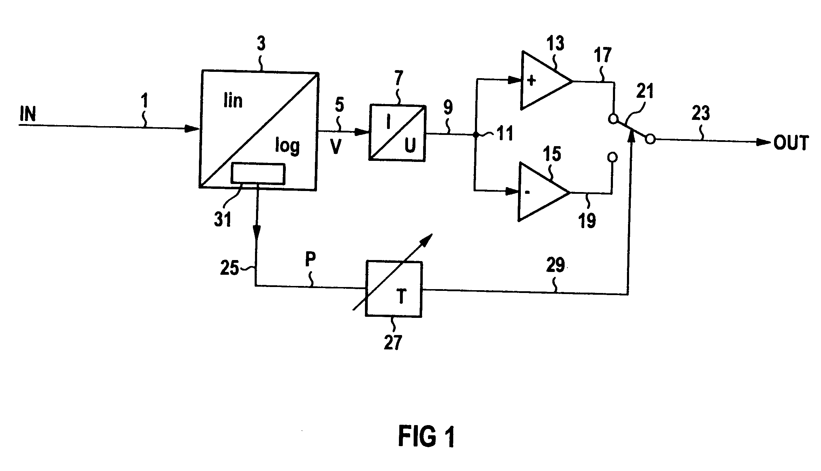

Figur 1 zeigt eine Eingangsleitung 1, an der das analoge Ausgangssignal eines Ultraschallempfängers 2 anliegt. Dieses Ausgangssignal bildet das Eingangssignal oder Ultraschallmesssignal IN, das über die Eingangsleitung 1 einem logarithmischen Verstärker 3 zugeführt ist. Ein an einem Stromausgang des logarithmischen Verstärkers 3 abgegriffenes Verstärkerausgangssignal V ist über eine erste Verbindungsleitung 5 einem Strom-Spannungs-Wandler 7 zugeführt. Ein Spannungsausgang des Strom-Spannungs-Wandlers 7 ist über eine zweite Verbindungsleitung 9 zu einer Verzweigung 11 geführt.

Falls der logarithmische Verstärker 3 einen Spannungsausgang mit ausreichend großer Bandbreite aufweist, kann der gesonderte Strom-Spannungs-Wandler 7 entfallen, so daß dann die erste Verbindungsleitung 5 unmittelbar mit der Verzweigung 11 in Verbindung stünde.

Die Verzweigung 11 ist mit einem nicht-invertierenden Verstärker 13 einerseits und mit einem parallel geschalteten Invertierer 15 oder invertierenden Verstärker andererseits verbunden. Der nicht-invertierende Verstärker 13 und der Invertierer 15 sind betragsmäßig auf die gleiche Verstärkung, die insbesondere den Wert 1 hat, eingestellt. Der nicht-invertierende Verstärker 15 dient zur Entkopplung und zur Laufzeitanpassung.

Ein nicht-invertierender Ausgang 17 des nicht-invertierenden Verstärkers 3 und ein invertierender Ausgang 19 des Invertierers 15 sind einem elektronischen Schalter 21 auf Halbleiterbasis zugeführt, der wechselweise zwischen den beiden Ausgängen 17, 19 hin und her schaltet. Die Gegenseite eines als Kontaktstück wirkenden Teils des Schalters 21 steht dabei stets mit einer Ausgangsleitung 23 in Verbindung, an der ein Ausgangssignal OUT abgreifbar ist.

Im weiteren wird beschrieben, wie das Hin-und-Her-Schalten des Schalters 21 gesteuert ist. Hierzu ist an einem begrenzten Limiterausgang 25 des logarithmischen Verstärkers 3 ein Polaritätssignal P abgegriffen und einem Anpaßglied 27 zugeführt, das über eine Steuerleitung 29 auf den Schalter 21 wirkt. Es wird also mit Hilfe des Polaritätssignals P die Funktion des Schalters 21 gesteuert. Beispielsweise findet bei einem Vorzeichenwechsel im Polaritätssignal P - gegebenenfalls zeitverzögert - ein Schaltvorgang im Schalter 21 statt. Das Anpaßglied 27 dient dabei sowohl der Laufzeit- als auch der Pegelanpassung.

In dem Anpaßglied 27 ist hierzu insbesondere eine Verzögerungszeit T einstellbar, mit der eine mögliche längere Laufzeit des Eingangssignals IN, bedingt durch den logarithmischen Verstärker 3, den Strom-Spannungs-Wandler 7 und den nicht-invertierenden Verstärker 13 bzw. den Invertierer 15, ausgleichbar ist, so daß im Schalter 21 das invertiere Signal und das nicht-invertierte Signal zeitrichtig zusammengesetzt werden.

Der logarithmische Verstärker 3 ist ein unipolarer oder demodulierender logarithmischer Verstärker vom Typ AD606 (Analog Devices). Bei diesem neunstufigen, nach dem Prinzip der "successive detection" arbeitenden logarithmischen Verstärker ist das Ausgangssignal der Endstufe (final limiter) einem Limiterausgang zugeführt. Diese Endstufe bildet zusammen mit einer entsprechenden Verbindungsleitung eine inhärent im integrierten Schaltkreis des AD606 vorhandene Polarisationserkennungseinheit 31. Ein solcher die Begrenzung des Ausgangssignals anzeigender Limiterausgang wird bei anderen Herstellern auch als "balanced limited output", "limited IF output" oder einfach als "limiter output", bezeichnet.

Der preiswerte verwendete demodulierende logarithmische Verstärker 3 hat einen Dynamikumfang von 80 dB, eine Frequenzbandbreite von 50 MHz und eine Abweichung von der Linearität über den Aussteuerbereich von typisch 0,4 dB. Diese Eigenschaften sind technisch nur möglich, weil der AD606 gleichgerichtet und nicht bipolar arbeitet.

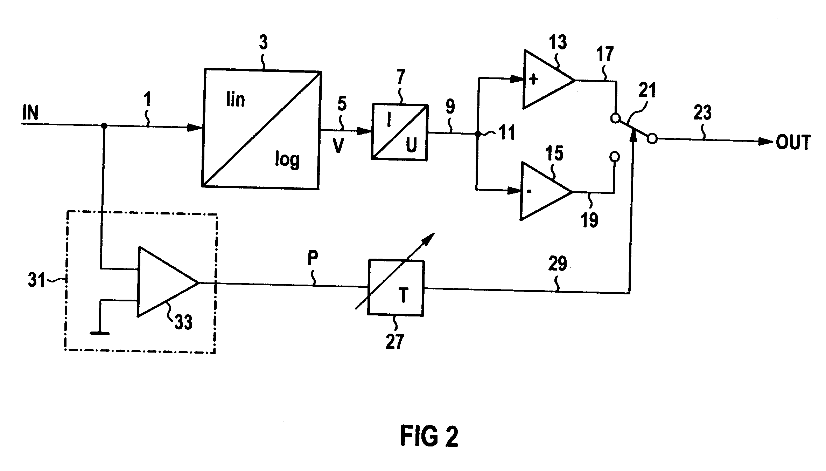

Figur 2 zeigt ein zweites Ausführungsbeispiel einer Vorrichtung nach der Erfindung in der ersten Ausführungsform, bei dem das Polaritätssignal P in einer vom logarithmischen Verstärker 3 gesondert vorhandenen Polarisationserkennungseinheit 31 erzeugt ist. Die Polarisationserkennungseinheit 31 weist einen Nulldurchgangskomparator 33 auf, dem das Eingangssignal IN zugeführt ist. Der Ausgang des Nulldurchgangskomparators 33 steht über das Anpaßglied 27 und die Steuerleitung 29 mit dem Schalter 21 in Verbindung. Im übrigen ist dieses zweite Ausführungsbeispiel mit dem ersten Ausführungsbeispiel identisch. Beim ersten Ausführungsbeispiel liefert der Limiterausgang 25 ein Signal, das dem Ausgangssignal des Nulldurchgangskomparators 33 bezogen auf das Eingangssignal IN entspricht.

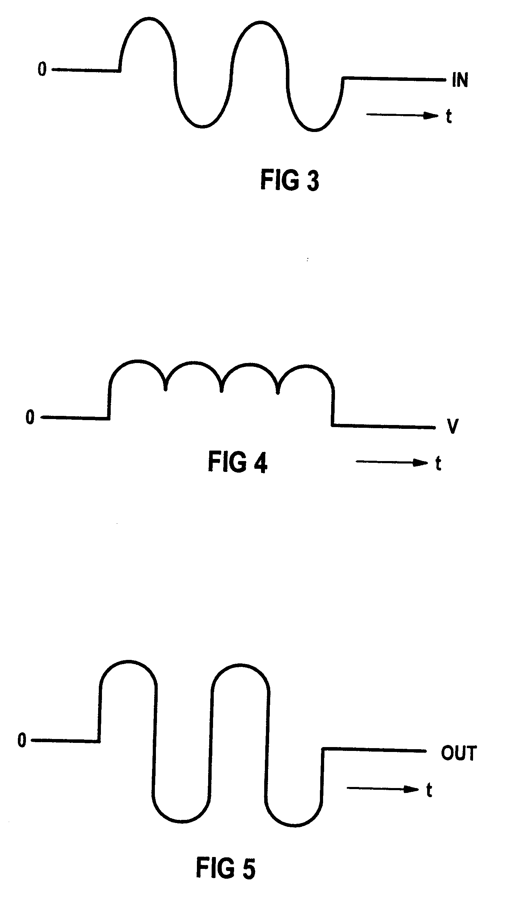

Figur 3 zeigt einen beispielhaften Verlauf des Eingangssignals IN über der Zeit t. Das Eingangssignal IN weist alternierendes Vorzeichen (Polarität) auf.

Figur 4 zeigt das Verstärkerausgangssignal V des demodulierenden logarithmischen Verstärkers 3 nach der Strom-Spannungs-Wandlung, das gegenüber dem Eingangssignal IN gleichgerichtet und verstärkt ist. In diesem Signal sind die einzelnen Halbwellenmaxima noch zeitlich auflösbar.

Figur 5 zeigt das gewünschte, mit den Vorrichtungen nach der Erfindung ermittelte Ausgangssignal OUT im zeitlichen Verlauf. Das - unter Umständen zeitverzögerte - Ausgangssignal OUT wechselt seine Polarität dann, wenn auch das Eingangssignal IN die Polarität wechselt. In den Zeitphasen konstanter Polarität wird das Eingangssignal IN betragsmäßig jeweils logarithmusartig in das Ausgangssignal OUT umgewandelt, insbesondere verstärkt. Unter "logarithmusartig" ist dabei zu verstehen, daß das Ausgangssignal OUT gemäß einer logarithmischen Transferfunktion vom Eingangssignal IN abhängt. Dabei muß die Transferfunktion keine exakte mathematische Funktion sein. Vielmehr kann die Transferfunktion auch eine Approximation einer exakten mathematischen Funktion darstellen. In anderen Worten: Es können - insbesondere geringfügige - Nichtlinearitäten in der halblogarithmisch aufgetragenen Transferfunktion vorhanden sein.

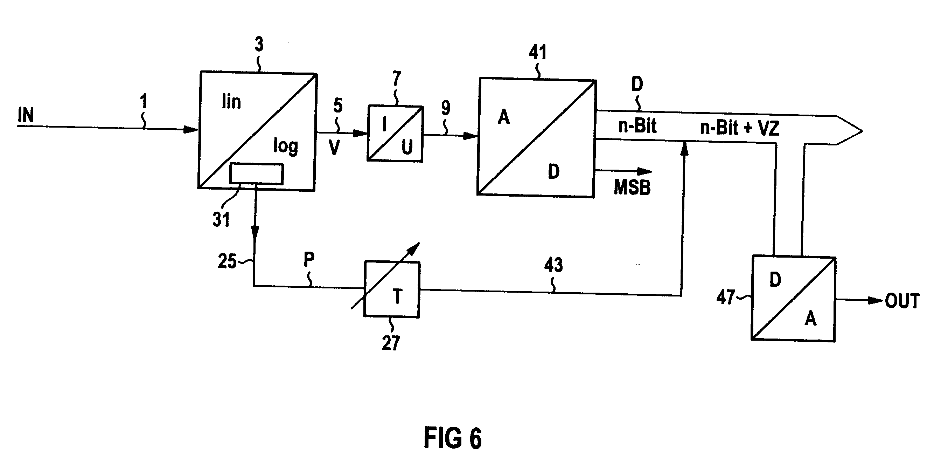

Bei dem in Figur 6 dargestellten dritten Ausführungsbeispiel ist das Polarisationssignal P wie beim ersten Ausführungsbeispiel von einer im logarithmischen Verstärker 3 vorhandenen Polarisationserkennungseinheit 31 über einen Limiterausgang 25 abgeleitet. Das dritte Ausführungsbeispiel unterscheidet sich jedoch von dem Ausführungsbeispiel der Figur 1 dadurch, daß die vom Strom-Spannungs-Wandler 7 ausgehende zweite Verbindungsleitung 9 einem linearen, käuflich erhältlichen Analog-Digital-Wandler 41 zugeführt ist. Das von diesem Analog-Digital-Wandler 41 erzeugte Wandler-Vorzeichenbit MSB ist bei der Vorrichtung gemäß dem dritten Ausführungsbeispiel nicht verwendet. Statt dessen ist das Polaritätssignal P als Vorzeichenbit VZ benutzt. Hierzu ist das Anpaßglied 27 über eine das Polaritätssignal P führende SIGN-Leitung 43 mit dem digitalen Ausgang des Analog-Digital-Wandlers 41 verbunden. Das Vorzeichenbit VZ wird einem vom Analog-Digital-Wandler 41 ermittelten Digitalwert D mit n Bits hinzugefügt, so daß der Digitalwert D dann aus n Bit und dem zusätzlichen Vorzeichenbit VZ besteht.

Der Analog-Digital-Wandler 41 führt eine lineare Digitalisierung ("Fixed-Point-Format") des Ausgangssignals V des logarithmischen Verstärkers 3 durch.

Der Digitalwert D mit dem aus der SIGN-Leitung 43 hinzugefügten Vorzeichenbit VZ bildet das Ausgangssignal OUT in digitaler Form.

Falls das Ausgangssignal OUT in analoger Form benötigt wird, kann dem Analog-Digital-Wandler 41 ein Digital-Analog-Umsetzer 47 nachgeschaltet sein, dem der Digitalwert D mit dem Vorzeichenbit VZ zugeführt ist. Am Ausgang des Digital-Analog-Umsetzers 47 steht dann ein analoges bipolares logarithmiertes Signal zur visuellen Betrachtung oder zur weiteren Verarbeitung zur Verfügung.

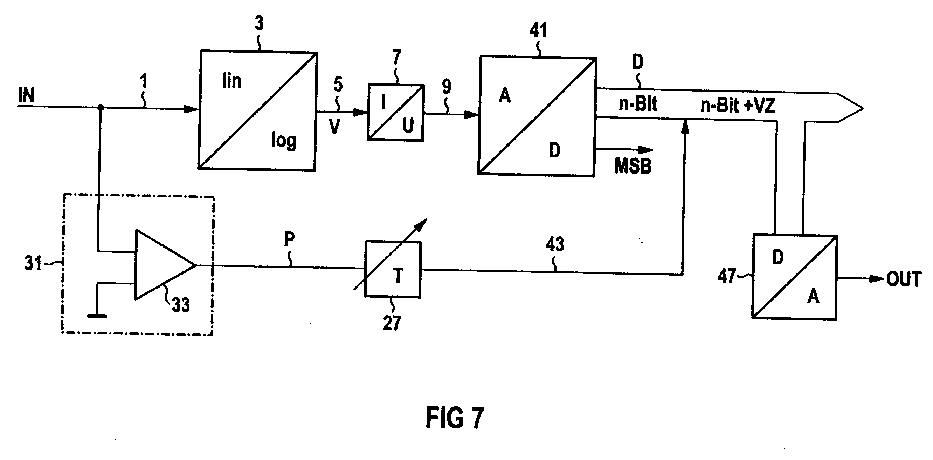

Das in Figur 7 dargestellte vierte Ausführungsbeispiel entspricht weitgehend dem in Figur 6 dargestellten dritten Ausführungsbeispiel, wobei jedoch im Unterschied hierzu die Erzeugung des Polaritätssignals P wie bei dem in Figur 2 dargestellten zweiten Ausführungsbeispiel mittels eines Nulldurchgangskomparators 33 realisiert ist.

Anstelle des Ultraschallmesssignals ist mit dem Verfahren nach der Erfindung auch ein beliebiges Eingangssignal, insbesondere ein beliebiges Detektorsignal, umwandelbar.

Vorteilig an den aufgezeigten Ausführungsbeispielen ist auch, dass nur ein einziger logarithmischer Verstärker (pro Kanal) nötig ist.

## Patentansprüche

1. Verfahren zur Umwandlung eines analogen Ultraschallmesssignals (IN) in ein Ausgangssignal (OUT), dessen Polarität von der Polarität des Ultraschallmesssignals (IN) beeinflußbar ist und dessen Betrag logarithmusartig vom Betrag des Ultraschallmesssignals (IN) abhängt,
**dadurch gekennzeichnet**,
a) daß aus dem Ultraschallmesssignal (IN) ein Polaritätssignal (P) erzeugt wird, das eine Information über die momentane Polarität des Ultraschallmesssignals (IN) enthält,
b) daß das Ultraschallmesssignal (IN) einem logarithmischen Verstärker (3) zugeführt wird,
c) daß aus einem Verstärkerausgangssignal (V) ein nicht-invertiertes Signal und ein invertiertes Signal erzeugt wird, das die gleiche bzw. entgegengesetzte Polarität wie das Verstärkerausgangssignal (V) aufweist, und
d) daß das Ausgangssignal (OUT) in Abhängigkeit vom Polaritätssignal (P) in zeitlicher Reihenfolge abwechselnd entweder aus dem nicht-invertierten Signal oder aus dem invertierten Signal gebildet wird.

2. Verfahren zur Umwandlung eines analogen Ultraschallmesssignals (IN) in ein Ausgangssignal (OUT), dessen Polarität von der Polarität des Ultraschallmesssignals (IN) beeinflußbar ist und dessen Betrag logarithmusartig vom Betrag des Ultraschallmesssignals (IN) abhängt,
**dadurch gekennzeichnet**,
a) daß aus dem Ultraschallmesssignal (IN) ein Polaritätssignal (P) erzeugt wird, das eine Information über die momentane Polarität des Ultraschallmesssignals (IN) enthält,
b) daß das Ultraschallmesssignal (IN) einem logarithmischen Verstärker (3) zugeführt wird,
c) daß ein Verstärkerausgangssignal (V) einem Analog-Digital-Wandler (41) zugeführt wird, der als Ausgangssignal einen Digitalwert (D) ermittelt, und
d) daß dem Digitalwert (D) ein aus dem Polaritätssignal (P) erzeugtes Vorzeichenbit (VZ) zur Bildung des Ausgangssignals (OUT) in digitaler Form hinzugefügt wird.

3. Verfahren nach Anspruch 2,
**dadurch gekennzeichnet**, daß aus dem Digitalwert (D) mittels eines Digital-Analog-Umsetzers (47) unter Berücksichtigung des Vorzeichenbits (VZ) das Ausgangssignal (OUT) in analoger Form erzeugt wird.

4. Verfahren nach einem der Ansprüche 1 bis 3,
**dadurch gekennzeichnet**, daß der logarithmische Verstärker (3) ein demodulierender logarithmischer Verstärker ist.

5. Verfahren nach einem der Ansprüche 1 bis 4,
**dadurch gekennzeichnet**, daß der logarithmische Verstärker (3) ein integrierter Schaltkreis ist, an dem das Polaritätssignal (P) abgreifbar ist.

6. Verfahren nach einem der Ansprüche 1 bis 5,
**dadurch gekennzeichnet**, daß der logarithmische Verstärker (3) ein nach dem Prinzip der "successive detection" arbeitender mehrstufiger Verstärker ist.

7. Verfahren nach einem der Ansprüche 1 bis 6,
**dadurch gekennzeichnet**, dass an einem begrenzten Limiterausgang (25) des logarithmischen Verstärkers (3) das Polaritätssignal (P) abgegriffen wird.

8. Verfahren nach einem der Ansprüche 1 bis 6,
**dadurch gekennzeichnet**, daß das Polaritätssignal (P) am Ausgang eines Nulldurchgangskomparators (33) abgegriffen wird, dem ein vom Ultraschallmesssignal (IN) abhängiges Signal zugeführt wird.

9. Vorrichtung zur Umwandlung eines analogen Ultraschallmesssignals (IN) in ein Ausgangssignal (OUT), dessen Polarität von der Polarität des Ultraschallmesssignals (IN) beeinflußbar ist und dessen Betrag logarithmusartig vom Betrag des Ultraschallmesssignals (IN) abhängt,
**gekennzeichnet durch**
a) eine Polaritätserkennungseinheit (31) zur Ermittlung der momentanen Polarität des Ultraschallmesssignals (IN),
b) einen logarithmischen Verstärker (3), dem das Ultraschallmesssignal (IN) zuführbar ist,
c) einen dem logarithmischen Verstärker (3) nachgeschalteten Invertierer (15) zum Erzeugen eines invertierten Signals aus dem Verstärkerausgangssignal (V), wobei das invertierte Signal entgegengesetzte Polarität wie das Verstärkerausgangssignal (V) aufweist, und
d) einen mit der Polaritätserkennungseinheit (31) über eine Steuerleitung (29) in Verbindung stehenden Schalter (21), mit dem in zeitlicher Reihenfolge abwechselnd entweder ein vom Verstärkerausgangssignal (V) abhängiges nicht-invertiertes Signal oder das invertierte Signal als Ausgangssignal (OUT) einer Ausgangsleitung (23) zuführbar ist.

10. Vorrichtung zur Umwandlung eines analogen Ultraschallmesssignals (IN) in ein Ausgangssignal (OUT), dessen Polarität von der Polarität des Ultraschallmesssignals (IN) beeinflußbar ist und dessen Betrag logarithmusartig vom Betrag des Ultraschallmesssignals (IN) abhängt,
**gekennzeichnet durch**
a) eine Polaritätserkennungseinheit (31) zur Ermittlung der momentanen Polarität des Ultraschallmesssignals (IN),
b) einen logarithmischen Verstärker (3), dem das Ultraschallmesssignal (IN) zuführbar ist,
c) einen dem logarithmischen Verstärker (3) nachgeschalteten Analog-Digital-Wandler (41) , der als Ausgangssignal einen Digitalwert (D) ermittelt, und
d) eine von der Polaritätserkennungseinheit (31) ausgehende SIGN-Leitung (43), mit der dem Digitalwert (D) zusätzlich ein Vorzeichenbit (VZ) zur Bildung des Ausgangssignals (OUT) in digitaler Form zuführbar ist.

11. Vorrichtung nach Anspruch 10,
**gekennzeichnet durch** einen dem Analog-Digital-Wandler (41) nachgeschalteten Digital-Analog-Umsetzer (47), mit dem aus dem Digitalwert (D) unter Berücksichtigung des Vorzeichenbits (VZ) das Ausgangssignal (OUT) in analoger Form erzeugbar ist.

12. Vorrichtung nach einem der Ansprüche 9 bis 11,
**dadurch gekennzeichnet**, daß der logarithmische Verstärker (3) ein demodulierender logarithmischer Verstärker ist.

13. Vorrichtung nach einem der Ansprüche 9 bis 12,
**dadurch gekennzeichnet**, daß der logarithmische Verstärker (3) und die Polaritätserkennungseinheit (31) als integrierte Schaltkreise ausgebildet sind.

14. Vorrichtung nach einem der Ansprüche 9 bis 13,
**dadurch gekennzeichnet**, daß der logarithmische Verstärker (3) ein nach dem Prinzip der "successive detection" arbeitender mehrstufiger Verstärker ist.

15. Vorrichtung nach Anspruch 14,
**dadurch gekennzeichnet**, daß die Polaritätserkennungseinheit (31) funktionell gebildet ist durch eine Endstufe des logarithmischen Verstärkers (3) und einen von der Endstufe ausgehenden begrenzten Limiterausgang (25), wobei der Limiterausgang (25) mit der Steuerleitung (29) bzw. der SIGN-Leitung (43) in Verbindung steht.

16. Vorrichtung nach einem der Ansprüche 9, 12 bis 14 oder nach einem der Ansprüche 10 bis 14,
**dadurch gekennzeichnet**, daß die Polaritätserkennungseinheit (31) ein Nulldurchgangskomparator (33) ist, dem ein vom Ultraschallmesssignal (IN) abhängiges Signal zuführbar ist und dessen Ausgang mit der Steuerleitung (29) bzw. der SIGN-Leitung (43) in Verbindung steht.
